Europäisches Patentamt

European Patent Office

Office européen des brevets

(19)

(11)    EP 1 073 776 B1

(12)    **EUROPEAN PATENT SPECIFICATION**

(45) Date of publication and mention
of the grant of the patent:
**12.06.2002  Bulletin 2002/24**

(21) Application number: **99914878.6**

(22) Date of filing: **23.03.1999**

(51) Int Cl.⁷: **C23C 14/30**

(86) International application number:
**PCT/UA99/00005**

(87) International publication number:
**WO 99/49100 (30.09.1999 Gazette 1999/39)**

(54) **METHOD FOR ELECTRON BEAM APPLYING LEADER FREE COATING**

ELEKTRONENSTRAHLVERFAHREN ZUM AUFBRINGEN VON BESCHICHTUNGEN OHNE
WACHSTUMSDEFEKTE

PROCEDE D'APPLICATION DE REVETEMENTS SANS AMORCE PAR FAISCEAU D'ELECTRONS

(84) Designated Contracting States:
**DE ES FR GB NL**

(30) Priority: **23.03.1998  UA 98031444**

(43) Date of publication of application:
**07.02.2001  Bulletin 2001/06**

(73) Proprietors:
  • **UNITED TECHNOLOGIES CORPORATION
    Hartford, CT 06101 (US)**
  • **International Center for Electron Beam
    Technologies of E.O. Paton Electric Welding
    Institute
    Kiev 252005 (UA)**

(72) Inventors:
  • **TOPAL, Valery I.
    Kiev, 252098 (UA)**

  • **BELYAVIN, Alexandr F.
    Kiev, 254211 (UA)**
  • **BRATUS, Vasily Ja.
    Kiev, 253057 (UA)**

(74) Representative: **Leckey, David Herbert
    Frank B. Dehn & Co.,
    European Patent Attorneys,
    179 Queen Victoria Street
    London EC4V 4EL (GB)**

(56) References cited:
    **WO-A1-95/12008        US-A- 3 928 026
    US-A- 4 419 416        US-A- 4 585 481
    US-A- 5 698 273**

**Description**

Technical Field

The present invention is directed to methods for applying metallic coatings by Electron Beam - Physical Vapor Deposition (EB-PVD) wherein the coatings are either leader free ones or have leaders that can be easily eliminated by thermal treatments at moderate temperature.

Background of the Invention

United States Patents: 3,021,271; 3,736,242; 4,036,723; 4,038,171; 4,006,070; 4,109,070; 4,109,061; 4,336,118; and 4,468,437 describe various aspects of the prior art which relates to this invention.

The methods of Physical vapor deposition (PVD) under vacuum are used in various fields of engineering to produce coatings, foils, and other types of deposited structures. These methods include sputtering, deposition by evaporation, ion plating, and neutralized ion beam coating. A common characteristic of the above methods is the ability to produce materials with non-equilibrium structure by deposition of the evaporation material through a process of the line-of-sight (i.e., direct access) between a source material and a substrate. Over the last years, such processes have been used to deposit a variety of source materials, including complex alloys and ceramics. For example, the process of electron beam physical vapor deposition has been used to apply protective metallic coatings to gas turbine engine components to enhance oxidation and corrosion resistance. One group of such coatings, having a general composition of MCrAlY coatings where M is Fe, Ni, Co, or Ni/Co, is described in detail in the US Patent 3,928,026 to Hecht et al. The above coatings have been used either by themselves as protective coatings, or as bond coats for multi-layer coating systems on gas turbine engine airfoils.

Although PVD metallic coatings have been widely used for many years, one of their drawbacks is presence of growth defects, the so-called leaders that form during deposition or cooling immediately after deposition. Leaders being linear macroscopic defects usually propagate from the condensation surface to the surface of the substrate (airfoil or other part being coated). Hence, reactive elements, such as oxygen or corrosive gases, vapors or liquids, can infiltrate along the inner surfaces of the leaders to the substrate's surface. As a result, oxidation or corrosion of the substrate surface (airfoil surface) takes place causing failure of the coating and/or the substrate. Besides the above-said, the presence of leaders also makes such coatings more susceptible to mechanical failure. In addition, leader-containing coatings often have rougher surfaces which is highly undesirable for use on gas turbine engine components. The aforementioned causes restrict large-scale application of protective metal coating produced in particular by EB PVD.

Several techniques have been tried out up to now by various researchers to eliminate macroscopic leaders from coatings and films without significant progress. For example, with aligning of the vapor flux perpendicular to the substrate (so that the incidence angle of the material being deposited to the substrate is small) it is rather easy to produce a uniform, dense coating practically without such growth defects as leaders. However, this technique is applicable only in the case of coating deposition on parts with simple geometry (flat plates of a small area), it does not work well on complex three-dimensional surfaces, such as gas turbine engine airfoils. During PVD in the last case, the vapor flux incidence angle is typically large, resulting in a coating with poor initial quality. Also, some parts must be uniformly coated on all surfaces which implies the use of rather complex devices for three-dimensional rotation. Part rotation plays an important role in leader formation during coating or film growth, which is attributable both to the so-called overshadow effects and to change of the instant values of the angle of vapor flux incidence and of linear velocity of substrate displacement.

It being impossible to produce homogeneous leader free coatings on complex geometry parts directly during coating, the typical approach is to eliminate leaders after coating deposition. One technique involves heating a coated substrate to enhance lateral thermal diffusion and to cause columnar grains that bound the leaders to grow together. Heating the coated substrate to a temperature sufficient to cause the columnar grains to grow together (e.g., to about 80% of the coating's absolute melting point) causes phase segregation in the coating. Phase segregation reduces the structural and compositional homogeneity of the entire coating. Consequently, one of the principal purposes of PVD, namely obtaining a non-equilibrium, homogeneous coating structure and composition, is defeated. Another problem with such high temperature treatment is that it tends to increase grain size in the coating. The disadvantages of an equilibrium structure, or an inhomogeneous composition, or large grain size are readily apparent to persons skilled in the coating art.

A similar technique involves applying the coating at an elevated temperature so that lateral diffusion sufficient to produce a dense coating occurs during coating deposition. The disadvantages of this method are similar to those for post-deposition heat treatment.

The most common method of leader elimination is a combination of mechanical means, for example shot peening, and heat treatment. Peening induces the elastic stresses and/or closes mechanically the leaders, reducing the temperature needed for an effective heat treatment. Heat treating at a lower temperature reduces the phase segregation and grain growth problems described above. Peening, however, can degrade adherence between the coating and substrate, particularly if the substrate's Young's modulus differs substantially from the coating's modulus. A difference in Young's modulus between the coating and substrate can cause the coating to fracture at the coating-substrate interface. If the coating itself is brittle, it may not be possible to peen the coating without fracturing it.

The closest prior art for present invention is the method for electron beam deposition of coatings, provided in US Patent No. 4,109,061 of 22.08.78, IPC B32B, 15/00, C23C 15/00. This patent discloses a method for electron beam applying of leader free coatings which method comprises electron beam heating of coating material ingot, its evaporation and following physical deposition of vapor flux onto heated substrate in vacuum. In this method small negative bias is applied to substrate to get a coating or at least its layers free of leaders. Therefore, at least a part of vapor is ionized and the coating layer with modified composition and structure is formed. This layer has no leaders and lesser content of aluminum, thus increasing the layer ductility. Then the bias is disconnected and the coating layer of normal composition is formed over said modified layer. This method allows to really eliminate leaders extending from the coating surface to substrate surface, but change of the coating chemical composition due to bias may be a cause of undesirable effects at the operation conditions.

Therefore, a wide industry utilization of EB-PVD it is needed such method for producing metal coatings that provides substantially leader-free PVD coatings or coatings which contain leaders but wherein the leaders can be eliminated thermally without the defects previously described.

The Essence of the Invention

The present invention is directed to improve method for applying electron beam leader free coatings on metal substrates in vacuum, wherein applying of leader free coatings or coatings having leaders that can be easily eliminated by thermal treatment is provided by realizing the process of coating material evaporation and vapor deposition under prescribed set of process parameters.

This problem was solved by providing method for applying electron beam leader free coatings which is comprised of electron-beam heating of the coating material ingot, its evaporation and resultant physical deposition of the vapor flux onto a heated substrate in vacuum, wherein **according to the invention** said ingot is evaporated and said vapor flux is deposited at the deposition temperature $T_{dep}$; the ingot feeding rate $V_{ing}$ and the vapor flux depositing rate $V_{dep}$ which are selected within three-dimensional region with such co-ordinates of its corner limiting points:

|   | $T_{dep}(°C)$ | $V_{ing}(mm/min)$ | $V_{dep}(μ/min)$ |
|---|---|---|---|
| A | 930 | 0.5 | 4.8 |
| B | 930 | 1.5 | 15. |
| C | 930 | 0.5 | 4.8 |
| D | 930 | 1.5 | 15 |
| E | 840 | 0.5 | 4.8 |
| F | 800 | 1.5 | 15 |
| G | 800 | 0.5 | 4.8 |
| H | 800 | 1.5 | 15 |

It is such selection of said parameters within of said three-dimensional region that provides the reproduction of evaporated material composition in the applied coating and the absence of leaders in the applied coating.

It is preferable to evaporate the coating material ingot of the following composition (percentage by weight): Fe, Ni, Co, and mixtures of Ni + Co = Balance; Cr = 5-40; Al = 5-35; Y =0.1-2.0; Si =0.1-2.0; Hf =0.1-2,0; Ce, Ru, Re, Ta, Pt, La, Pd, Ti, Zr, Nb and Os and mixtures thereof = 0-15.

Brief Description of the Drawing

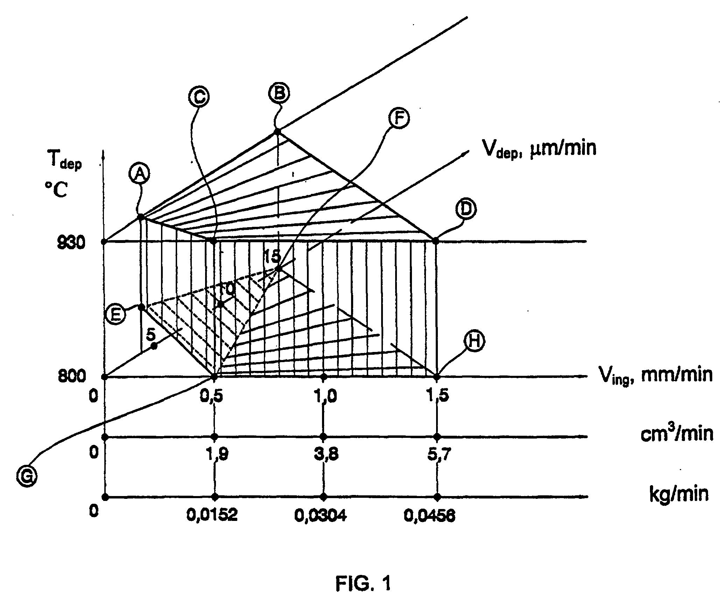

FIG. 1 shows three-dimensional region in the space of such co-ordinates: substrate temperature ($T_{dep}$), ingot feeding rate ($V_{ing}$) and deposition rate ($V_{dep}$), from which the conditions of ingot evaporation and vapor flux deposition are selected to achieve leader free MCrAlY coatings.

Preferable Embodiment of the Invention

The method of the invention pertains to evaporation processes used for production of leader free condensed metallic coating, in particularly MCrAlY(+X) type alloy coatings, where M is Fe, Ni, Co and mixture Ni-Co, and X denotes additions of Si, Ce, Ru, Re, Hf, Ta, Pt, La, Pd, Ti, Zr, Nb, and Os and mixtures thereof, as independent coating or a bond coat in a multi-layer system. The method was developed and proven in the production unites for electron beam physical vapor deposition (EB-PVD) under vacuum. The working vacuum was in the range from $4.10^{-3}$ up to $1\text{-}10^{-2}$ Pa, the initial roughness of deposited surfaces being $R_a$ = 0.8 microns.

The proposed method uses high-speed evaporation of alloys. It provides high diffusion mobility of vapor flux atoms on the substrate caused by: (i) increasing pool surface temperature due to providing effective temperature gradient through the pool section, (ii) using high-frequency scanning of electron beam, (iii) adding to the pool the refractory components which increase the melt viscosity and thereby decrease the heat losses due to convective mixing.

The total individual atom (or atom cluster) energy in the evaporation process is the sum of kinetic and potential energy. Considering the case of flux expansion into vacuum, the evaporating atoms have the velocity distribution in accordance with Maxwell's equation and the root-mean-square atom velocity which defines the mean kinetic energy, is

$$V_{at} = (\frac{8kT_0}{\pi m})^{1/2}$$

where k=Bolzman's constant, $T_0$=surface temperature, m=atomic weight. Consequently, the increase of the total kinetic flux energy is directly proportional to the increase of the mean evaporation surface temperature. The mass vapor flux velocity directed normally to evaporation surface, e.g., vapor flux, is also increased with the surface temperature.

The structure of the as deposited coating is characterized by the non-equilibrium fine grain structure, the mean grain size is of the order 1-2 μm (microns) with the aspect ratio (of the average grain dimension perpendicular to the substrate to the average grain dimension parallel to the substrate) of about to 1:1 to 2:1. Usually, non-equilibrium structures are characterized by the abnormal physical properties, including accelerated internal boundary diffusion. In the case of vapor deposited MCrAlY coatings, the phase composition has been identified as supersaturated M-based solid solution with extremely large area of interfaces. The equilibrium composition at deposition temperature has a two phase γ/α structure. During exposure at temperatures below the transition temperature, the as-deposited structure evolves towards the more equilibrium configuration. The diffusion activated transformations of γ - supersaturated phase into γ/α equilibrium state causes volume changes, effectively «healing» the existing leaders and decreasing the possibility of new leaders development.

The present invention involves the establishment of a particular range of parameters at which metallic coatings can be deposited by the EBPVD process, these coatings being either leader free or being made leader free through a moderate temperature thermal process without the necessity for prior mechanical deformation. Moderate temperature is defined as either (a) not more than 100° C above the temperature of practical use of the substrate material, and preferably not more than the temperature of practical use of the substrate material, or alternately (b) not more than 1200° C and preferably not more than 1100° C.

Figure 1 shows the three-dimension region determined by three parameters within which leader free or readily annealable leader containing metal coatings were obtained. Table I lists co-ordinates of comer limiting points of the region shown in Fig. 1.

Table I

|  | $T_{dep}$(°C) | $V_{ing}$(mm/min) | $V_{dep}$(μ/min) |
|---|---|---|---|
| A | 930 | 0.5 | 4.8 |
| B | 930 | 1.5 | 15. |
| C | 930 | 0.5 | 4.8 |
| D | 930 | 1.5 | 15 |
| E | 840 | 0.5 | 4.8 |
| F | 800 | 1.5 | 15 |
| G | 800 | 0.5 | 4.8 |
| H | 800 | 1.5 | 15 |

Figure 1 illustrates the process developed with specific reference to the MCrAlY coating compositions of the type which are described for example in US Patents 3,928,026, 4,419,416 and 5,582,635. A broad range of the materials which can be contained in this general type of coating is as follows (percentage by weight): Cr (chromium) - (5-40); Al (aluminum) - (5-35); Si (silicon) - (0.1- 2.0); rare-earth elements - (up to 2.0); such active elements as Re (rhenium), Pt (platinum), Pd (palladium), Zr (zirconium), Ti (titanium), Nb (niobium), Hf (hafnium), Ta (tantalum), Os, Ru (ruthenium) - (up to 15); the balance being Ni (nickel), Co (cobalt), Fe (iron) or Ni/Co mixture.

It has been found that the parameters shown in Figure 1, namely $T_{dep}$ (or the substrate temperature during deposition); $V_{dep}$ (the deposition rate of the coating on the substrate) and the $V_{ing}$, (the ingot feed rate which characterizes the volume rate of evaporation of the coating material), in combination, control presence or absence of leaders, and if leaders are present, these parameters control the ease of thermal elimination or healing of leaders.

Referring to Figure 1 we have found that the substrate temperature should range from about 800 to about 930° C for deposition of coatings of this type. The upper limit on substrate temperature is set by the tendency for the chromium constituent in the coating composition to reevaporate. Chromium has a high vapor pressure and if the substrate temperature exceeds about 930° C chromium reevaporation from the coating will cause a deficiency of chromium in the final coating. The substrate temperature should exceed about 800° C to promote lateral diffusion of as deposited coating atoms which reduces the likelihood of leader formation.

The other two parameters, $V_{dep}$ and $V_{ing}$ influence the energy of the as-deposited atoms (and atom clusters) and the total energy of the atomic flux colliding with the substrate. If either of these two parameters is beyond the region shown in Figure 1, the as-deposited atoms will have insufficient energy to activate surface diffusion or to diffuse in the direction perpendicular to the vapor flux direction or very high energy which will cause reevaporatin of elements having law vapor pressure and the change of chemical composition. At the first case, the absence of diffusion causes the initiation and propagation of the growth defects, in the other case re-evaporation causes changes of chemical composition and physical and mechanical properties of the coating.

The three parameters are slightly interrelated. Analysis shows such qualitative correlation.

1. The rate of evaporation with a certain fixture geometry (i.e. at invariable incidence angle of vapor flux) determines the deposition rate and the minimal temperature of the condensation surface. Increasing the rate of evaporation causes proportional increase in the flux energy and an increase in the substrate (part) temperature, respectively, due to both increasing the individual kinetic energy of the flux atoms (clusters) and to a more intensive evolution of the latent energy of condensation.

2. The deposition (condensation) rate depends in a great degree on the change of the vapor flux incidence angle in time. In addition it depends on the distance between a source and a deposition surface (i.e. on the geometry of momentary relative position of the substrate and the vapor flux) at a fixture rate of evaporation.

3. The condensation temperature depends on both the rates of evaporation and condensation and the power of the heating electron beam and radiation heating in accordance with the Stephan-Bolzman law. However, in the described process, the influence of electron beam heating is most important in the process terms. This influence is one of the process parameters that can be controlled most easily and precisely.

Maintenance of technology parameters of evaporation and condensation within the shaded area in Figure 1 (inside of the so called process envelope) allows production of a guaranteed bond coat which is leader free after deposition or has leaders which are of small size and can be healed by thermal healing at moderate temperatures, temperatures which do not dramatically interfere or modify the non-equilibrium nature of the deposit coatings.

If the MCrAlY bond coat is to be used as a bond coat for subsequent application for the ceramic coating by electron beam physical vapor deposition it will generally be the case that even if the as deposited bond coat (applied according to the invention) contains leaders, the substrate temperature conditions during the application of ceramic coatings (typically 1000-1100° C) will be sufficient to heal these leaders through diffusion.

The broad object is to provide a coating which does not have leaders extending from the surface to the substrate since such continuous leader defects are likely to be sites for subsequent coating failure. Since the broad object of the invention is the elimination of continuous leaders from the surface of the substrate it will be appreciated that a coating system in which the leaders are interrupted so that none of them are continuous to the substrate may be entirely satisfactory for certain applications. It is possible that only a portion of metallic bond coat need be applied under parameters within the shaded region of Figure 1. Preferably the bond coat region immediately adjacent the substrate is leader free and also the bond coat adjacent the external surface is leader free. Thus for example in the application of a 125 μm (5 mil) MCrAlY bond coat one my apply the initial 25 μm (1 mil) of coating under conditions within the shaded area in Figure 1, the next 75 μm (3 mil) might be applied under some other set of conditions which permit leader formation, and the last 25 μm (1 mil) - in the shade region in Figure 1 which prohibits leader formation. The result would be a coating with certain amount of leaders contained therein but leaders which are not connected with the surface and are much less deleterious to coating performance than the continuous leaders which have been observed in the prior art.

Considering the two possibilities, first that a leader free coating and the second that a coating containing healable leaders will be deposited, it is more likely that one will achieve initial leader free coating conditions at the upper ends of the three parameters in the shaded region of Figure 1, a higher deposition temperature, a higher rate of condensation and/or a greater rate of evaporation, all this enhancing the probability of production of a leader free as-deposited coating.

As previously described the coatings which can be applied according to the present invention are those of the MCrAlY type which contain iron, nickel, cobalt, mixtures of nickel cobalt, chromium, aluminum, and yttrium as their primary constituents. It is known and has been suggested that other ingredients might be added to these coatings for improvements in various operating environments. These added ingredients include silicon, hafnium, tantalum, rhenium, platinum, palladium, cerium, rhodium, ruthenium, lanthanum and others alone or in combination. Such added ingredients will generally be added singularly in amounts of less than about 5 weight percent and usually less than 3 weight percent and cumulatively, in amounts in weight percentages of less than about 10% and usually less than about 6 percent. These minor amounts of added elements do not have a significant effect on the position of the shaded area as shown in Figure 1. Accordingly these modified MCrAlY coating materials can readily be deposited under the conditions shown in Figure 1 to produce the coatings previously described which are either leader free or capable to be made leader free through thermal annealing and moderate temperatures.

The present invention may be better understood through reference of the following examples which are meant to be illustrative rather than limiting.

Example I

A full scale EBPVD coating apparatus was used to deposit MCrAlY coatings on commercial turbine blades having a total airfoil length of about 75 mm (3 inches). Six turbine blades were mounted in a carousel type fixture which provided rotation of the parts above the source of the coating material being evaporated. Because of the fixture geometry dimensions and rotation the stand off distance between the evaporation pool source and the part surface varied from about 200 to about 400 millimeters during the coating process.

The preheat source was an electron beam which was operated at an input power of about 10 to 12 kilowatts for a time of about 10 minutes and focused on carousel to provide direct EB and radiant preheating of the blades. An ingot of about 70 millimeters in diameter of a MCrAlY type alloy having a composition of about (percentage by weight) Ni-20%Co-20%Cr-11%Al-0.5%Y-0.4% Si was used for depositing. The electron beam power was held at about 50 to 55 kilowatts and the substrate temperature $T_{dep}$ was maintained in the range of about 850 to 880εC. The evaporation rate was approximately 1 millimeter per minute and the deposition rate was about 8 μm (microns) per minute. The structure of the as deposited coating was a fine grained and free from leaders. The leaders, which were present, were minor in size and number and had dimensions of less than one micron. All traces of these minor defects were eliminated during subsequent ceramic deposition process during which the bond coat temperature was maintained at about 1050°C for a period of about 1 hour. Vacuum annealing under the same temperature and time conditions will also eliminate these growth defects.

Example II

The apparatus and process of example I was used to deposit the same composition as Example I with the exception that the deposition temperature was maintained at a temperature of 830 to 850°C, the evaporation rate was 1 millimeter per minute and the deposition rate was less than 4.5 μm (microns) per minute. Numerous leaders were found in the fine-grained coating structure both in the as-deposited condition and after thermal annealing equivalent to that employed in Example I.

Examples III - X

The apparatus and procedure of Example was followed for Example III - X and the results are summarized in Table II.

Table II

| Example # | Sample # | $T_{dep.}$, °C | $V_{ing}$, mm/min | $V_{dep}$, μm/min | Leaders |
|---|---|---|---|---|---|
| 3 | 1 | 850-880 | 1.4 | 9.8 | none |
| 4 | 2 | 840-860 | 1.3 | 8.5 | none |

**EP 1 073 776 B1**

Table II   (continued)

| Example # | Sample # | $T_{dep.}$, °C | $V_{ing}$, mm/min | $V_{dep}$, μm/min | Leaders |
|---|---|---|---|---|---|
| 5 | 3 | 840-860 | 1.2 | 7.8 | none |
| 6 | 4 | 840 | 0.8 | 5.4 | healable leaders* |
| 7 | 5 | 820 | 0.95 | 7.7 | several leaders** |
| 8 | 6 | 900 | 0.9 | 6.2 | healable leaders* |
| 9 | 7 | 800 | 1.5-1.6 | 12.0 | healable leaders* |
| 10 | 8 | 850 | 1.8 | 16.0 | none (lost of Cr, Al) |

*Leaders were healed (eliminated) by subsequent exposure at 1050° C for one hour.

Industrial applicability

The utmost effect of the method for electron beam applying leader free coatings may be obtained especially for the application of MCrAlY coatings of the type commonly used in gas turbine applications.

**Claims**

1.   A method for electron beam applying leader free coatings which method comprises electron-beam heating of coating material ingot, its evaporation and following physical deposition of vapor flux onto heated substrate in vacuum, **characterized in that** said ingot is evaporated and said vapor flux is deposited under the deposition temperature $T_{dep}$; the ingot feeding rate $V_{ing}$ and the vapor flux depositing rate $V_{dep}$ which are selected within three-dimensional region as shown in Fig. 1 with such co-ordinates of its comer limiting points:

|   | $T_{dep}$(°C) | $V_{ing}$(mm/min) | $V_{dep}$(μ/min) |
|---|---|---|---|
| A | 930 | 0.5 | 4.8 |
| B | 930 | 1.5 | 15. |
| C | 930 | 0.5 | 4.8 |
| D | 930 | 1.5 | 15 |
| E | 840 | 0.5 | 4.8 |
| F | 800 | 1.5 | 15 |
| G | 800 | 0.5 | 4.8 |
| H | 800 | 1.5 | 15 |

2.   A method according to claim 1, **characterized in tha**t the coating material ingot of such compositions evaporated (percentage by weight):

Fe, Ni, Co, and mixtures of Ni + Co = Balance
Cr = 5-40
Al = 5-35
Y =0.1-2.0
Si =0.1-2.0
Hf =0.1-2,0

Ce, Ru, Re, Ta, Pt, La, Pd, Ti, Zr, Nb and Os and mixtures thereof = 0-15.

**Patentansprüche**

1.   Verfahren zur Elektronenstrahl-Aufbringung wachstumsfehlerfreier Beschichtungen, wobei das Verfahren die Elektronenstrahl-Erwärmung eines Ingots aus Beschichtungsmaterial, seine Verdampfung und danach die physikalische Abscheidung von Dampffluss auf ein erwärmtes Substrat im Vakuum aufweist,

**dadurch gekennzeichnet,**

**dass** der Ingot verdampft wird und der Dampffluss abgeschieden wird unter der Abscheidungstemperatur $T_{dep}$ der Ingot-Zuführrate $V_{ing}$ und der Dampffluss-Abscheidungsrate $V_{dep}$, die ausgewählt werden innerhalb des dreidimensionalen Bereichs, wie in Fig. 1 gezeigt, mit solchen Koordinaten seiner Eckbegrenzungspunkte:

|   | $T_{dep}(°C)$ | $V_{ing}$ (mm/min) | $V_{dep}(\mu m/min)$ |
|---|---|---|---|
| A | 930 | 0,5 | 4,8 |
| B | 930 | 1,5 | 15 |
| C | 930 | 0,5 | 4,8 |
| D | 930 | 1,5 | 15 |
| E | 840 | 0,5 | 4,8 |
| F | 800 | 1,5 | 15 |
| G | 800 | 0,5 | 4,8 |
| H | 800 | 1,5 | 15 |

2. Verfahren nach Anspruch 1,
   **dadurch gekennzeichnet,**
   **dass** der Ingot aus Beschichtungsmaterial solcher Zusammensetzungen verdampft (Gewichtsprozentsatz):

   Fe, Ni, Co, und Gemische von Ni + Co = Rest
   Cr = 5-40
   Al = 5-35
   Y = 0,1-2,0
   Si = 0,1 - 2,0
   Hf = 0,1-2,0

   Ce, Ru, Re, Ta, Pt, La, Pd, Ti, Zr, Nb und Os und Gemische davon = 0-15.


## Revendications

1. Procédé d'application par faisceau d'électrons de revêtements sans précurseur, lequel procédé comprend le chauffage par faisceau d'électrons d'un lingot du matériau de revêtement, son évaporation et ensuite le dépôt physique du flux de vapeur sur le substrat chauffé sous vide, **caractérisé en ce que** ledit lingot est évaporé et ledit flux de vapeur est déposé au-dessous de la température de dépôt $T_{dep}$ ; la vitesse d'amenée du lingot $V_{ing}$ et la vitesse de dépôt du flux de vapeur $V_{dep}$ étant sélectionnées dans la zone tridimensionnelle montrée sur la figure 1, avec de telles coordonnées de ses points de limitation d'angle :

|   | $T_{dep}(°C)$ | $V_{ing}(mm/min)$ | $V_{dep}(\mu/min)$ |
|---|---|---|---|
| A | 930 | 0,5 | 4,8 |
| B | 930 | 1,5 | 15 |
| C | 930 | 0,5 | 4,8 |
| D | 930 | 1,5 | 15 |
| E | 840 | 0,5 | 4,8 |
| F | 800 | 1,5 | 15 |
| G | 800 | 0,5 | 4,8 |
| H | 800 | 1,5 | 15 |

2. Procédé selon la revendication 1, **caractérisé en ce que** le lingot de matière de revêtement évaporé a la composition suivante (pourcentages en poids) :

   Fe, Ni, Co, et les mélanges de Ni + Co = reste
   Cr = 5 - 40
   Al = 5 - 35
   Y = 0,1 - 2,0

Si = 0,1 - 2,0
Hf = 0,1 - 2,0

Ce, Ru, Re, Ta, Pt, La, Pd, Ti, Zr, Nb et Os et les mélanges de ceux-ci = 0 - 15.

FIG. 1